# EUROPÄISCHE PATENTANMELDUNG

(11) **EP 1 840 963 A2**
(43) Veröffentlichungstag der Anmeldung: **03.10.2007**
(21) Anmeldenummer: 07005336.8
(22) Anmeldetag: 15.03.2007
(51) Int. Cl.: H01L 23/48

(54) **Druck kontaktierte Anordnung mit einem Leistungsbauelement, einem Metallformkörper und einer Verbindungseinrichtung**

(30) Priorität: 28.03.2006 DE 102006014145
(71) Anmelder: SEMIKRON Elektronik GmbH & Co. KG, 90431 Nürnberg (DE)
(72) Erfinder: Heilbronner, Heinrich Dr., 90547 Stein (DE)

(57) **Zusammenfassung**

Die Erfindung beschreibt eine Druck kontaktierte Anordnung mit einem Leistungsbauelement, einer Verbindungseinrichtung und einem ersten Metallformkörper zur Wärmeabfuhr. Das Leistungsbauelement ist hierbei mit seiner ersten Hauptfläche dem ersten Metallformkörper zugewandt angeordnet und elektrisch leitend mit diesem verbunden Die zweite Hauptfläche ist mit einer Kontakteinrichtung der Verbindungseinrichtung elektrisch leitend verbunden ist. Ein Gehäuse umschließt das Leistungsbauelement und schließt mittels einer Dichteinrichtung zum ersten Metallformkörper und zur Verbindungseinrichtung hin ab. Eine Druckeinrichtung leitet Druck auf das Gehäuse und / oder die Verbindungseinrichtung in Richtung des ersten Metallformkörpers ein.

## Beschreibung

Die Erfindung beschreibt eine Druck kontaktierte Anordnung mit mindestens einem Leistungsbauelement, einem Metallformkörper, der vorzugsweise als Kühlkörper ausgebildet ist, und einer Verbindungseinrichtung. Hierbei ist das Leistungsbauelement mit dem Metallformkörper elektrisch und thermisch leitend verbunden. Die gesamte Anordnung ist für hohe Temperaturbelastungen über 175°C und hohe Temperaturschwankungen bis über 150°C geeignet ausgebildet.

Grundsätzlich sind Ausgestaltungen derartiger Anordnungen seit langem bekannt. Hierbei ist das Leistungsbauelement mit der Verbindungseinrichtung als Schraubdiode bzw. Schraubthyristor oder als Pressfitdiode ausgebildet. Derartige Bauelemente weisen gemäß dem Stand der Technik ein metallisches Gehäuse, einen hierin angeordneten Halbleiterkörper und eine Verbindungseinrichtung auf.

Der Halbleiterkörper ist mit dem Gehäuse elektrisch leitend verbunden, wobei hier nach dem Stand der Technik Lötverbindungen Verwendung finden. Ebenso ist die Verbindungseinrichtung mit dem Halbleiterkörper löttechnisch verbunden. Es ist weiterhin bekannt, dass zwischen Halbleiterkörper und Gehäuse und / oder Verbindungseinrichtung ein weiterer Metallformkörper angeordnet ist. Dieser weist bevorzugt einen thermischen Ausdehnungskoeffizienten auf, der zwischen demjenigen des Halbleiterkörpers und demjenigen des Gehäuses bzw. der Verbindungseinrichtung liegt.

Zum Abschluss des Halbleiterkörpers gegenüber Umwelteinflüssen ist es bevorzugt, wenn das Gehäuse mit einem Kunststoff vergossen ist. Nachteilig an derartigen Bauelementen ist, dass sie durch ihre Ausgestaltung nur eine sehr begrenzte Temperaturbeständigkeit gegenüber Temperaturen von mehr als 150°C aufweisen. Ebenso ist die Dauerhaltbarkeit besonders bei hohen Temperaturwechselraten begrenzt.

Schraubdioden bzw. Schraubthyristoren werden nach dem Stand der Technik mit einem Metallformkörper, der meist auch als Kühleinrichtung dient, verschraubt und auch elektrisch kontaktiert. Pressfitdioden werden in einen Metallformkörper zur elektrischen Kontaktierung und Wärmeabfuhr eingepresst. Derartige Anordnungen finden häufig in der Automobilindustrie Anwendung.

Der Erfindung liegt die Aufgabe zugrunde eine Anordnung mit mindestens einem Leistungsbauelement, einer Verbindungseinrichtung und mindestens einem Metallformkörper zur Wärmeabfuhr und gleichermaßen elektrischen Kontaktierung des Leistungsbauelements vorzustellen, wobei diese Anordnung eine Temperaturbeständigkeit gegenüber Temperaturen von mehr als 175°C aufweist sowie für Temperaturschwankungen von über 150°C geeignet ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Druck kontaktierten Anordnung mit mindestens einem Leistungsbauelement, einer Verbindungseinrichtung und mindestens einem ersten Metallformkörper zur Wärmeabfuhr. Hierbei ist das Leistungsbauelement ausgebildet als ein Halbleiterkörper mit mindestens einem pn- Übergang. Derartige Leistungsbauelemente sind beispielhaft Dioden, Transistoren und Thyristoren. Erfindungsgemäß ist das mindestens eine Leistungsbauelement mit seiner ersten Hauptfläche dem Kühlbauteil zugewandt angeordnet und elektrisch leitend mit diesem verbunden.

Hierbei ist es bevorzugt, wenn zwischen Leistungsbauelement und Metallformkörper ein weiterer Metallformkörper angeordnet ist, um einen Ausgleich unterschiedlicher thermischer Ausdehnungskoeffizienten herbeizuführen. Hierbei ist es weiterhin besonders bevorzugt, wenn die Verbindung zwischen Leistungsbauelement und weiterem Metallformkörper als Drucksinterverbindung ausgebildet ist.

Die zweite Hauptfläche des Leistungsbauelements ist mit einer Kontakteinrichtung der Verbindungseinrichtung elektrisch leitend verbunden.

Ein Gehäuse umschließt mindestens ein Leistungsbauelement und schließt dieses mittels mindestens einer Dichteinrichtung zum ersten Metallformkörper und zur Verbindungseinrichtung hin ab. Die Druckkontaktierung wird ausgebildet durch eine Druckeinrichtung, die Druck auf das Gehäuse und / oder die Verbindungseinrichtung in Richtung des ersten Metallformkörpers einleitet.

Erfindungsgemäß weist die Anordnung keine Verbindungen, wie beispielhaft Lötverbindungen, auf, die nicht die geforderte Temperaturbeständigkeit bietet.

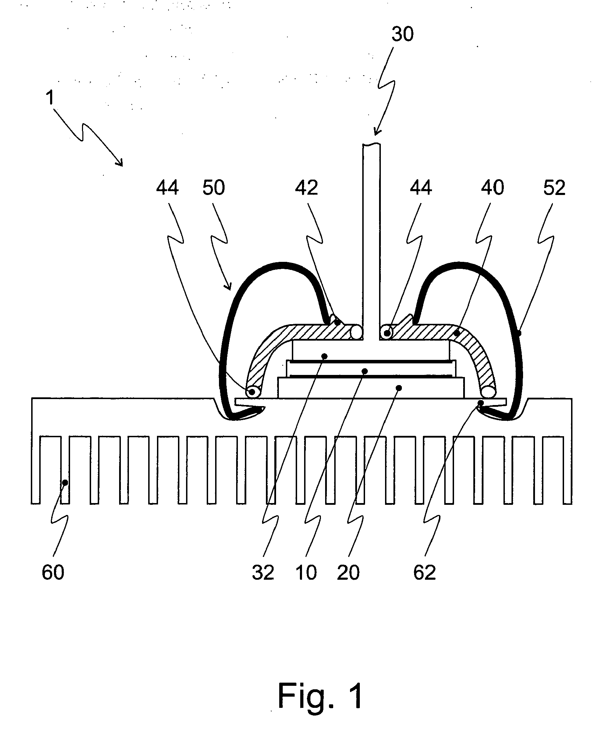

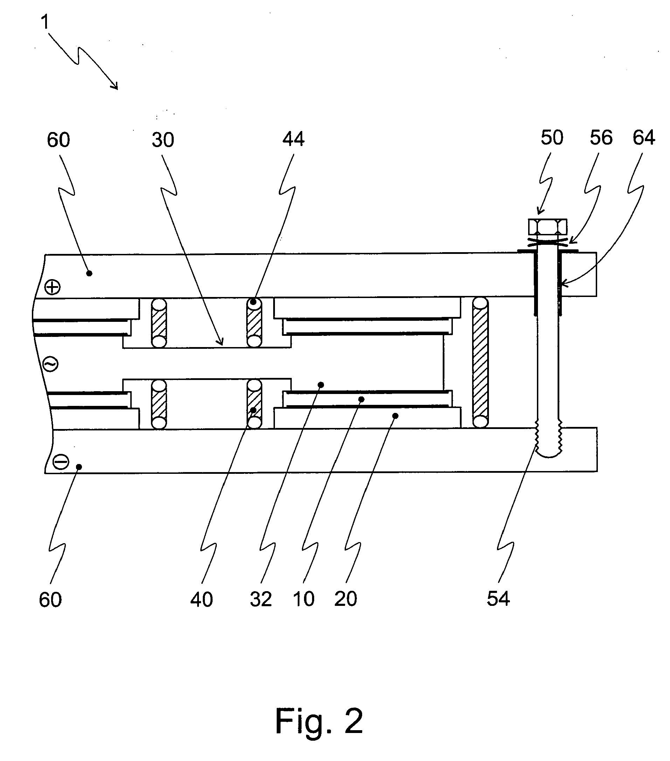

Die erfinderische Lösung wird anhand der Ausführungsbeispiele der Fig. 1 und 2 weiter erläutert.

Fig. 1 zeigt eine erste Ausgestaltung einer erfindungsgemäßen Anordnung.

Fig. 2 zeigt eine zweite Ausgestaltung einer erfindungsgemäßen Anordnung.

Fig. 1 zeigt eine erste Ausgestaltung einer erfindungsgemäßen Anordnung (1). Dargestellt ist ein Leistungsbauelement (10), hier eine Leistungsdiode. Deren Anode ist mit einem ersten Metallformkörper (60), der hier als Kühlkörper ausgebildet ist elektrisch leitend verbunden. Diese Verbindung ist ausgebildet, indem die Leistungsdiode (10) mit einem zweiten Metallformkörper (20) stoffschlüssig mittels einer Drucksinterverbindung verbunden ist. Hierbei überragt der zweite Metallformkörper (20) den Halbleiterkörper (10) der Leistungsdiode jeweils in lateraler Richtung. Dieser Verbund aus Leistungsdiode (10) und zweitem Metallformkörper (20) ist formschlüssig auf dem Kühlkörper (60) angeordnet.

Die Kathode der Leistungsdiode (10) ist mit einer Kontakteinrichtung (32) einer Verbindungseinrichtung (30) ebenfalls formschlüssig verbunden. Die Leistungsdiode (10) mit der Kontakteinrichtung (32) der Verbindungseinrichtung (30) und dem zweiten Metallformkörper (20) ist von einem Gehäuse (40) umschlossen. Zur Abdichtung gegen Umwelteinflüsse weist das Gehäuse bis über 200°C temperaturbeständige elastische Dichteinrichtungen (44) auf. Hiervon dichtet eine erste das Gehäuse (40) zum Kühlkörper (60) hin ab und die zweite dichtet das Gehäuse (40) zur Verbindungseinrichtung (30) hin ab. Alternativ allerdings nicht dargestellt kann es bevorzugt sein, wenn auf der dem Leistungsbauelement zugewandten Oberfläche des Gehäuses flächig eine geeignete Dichteinrichtung derart angeordnet ist, dass ein Abschluss des Leistungsbauelements gewährleistet ist.

Die formschlüssigen Verbindungen zwischen Kühlkörper (60) und zweitem Metallformkörper (20) sowie zwischen dem Leistungsbauelement (10) und der Verbindungseinrichtung (30) werden gebildet durch eine Druckbeaufschlagung des Gehäuses (40) mittels einer Druckeinrichtung (50). Diese Druckeinrichtung wird gebildet durch mindestens zwei, vorzugsweise drei, Halteklammern (52). Diese Halteklammern (52) stützen sich gegen je ein Widerlager (62) im oder am Kühlkörper (60) sowie gegen eine Halteeinrichtung (42) des Gehäuses (40) ab.

Mittels der Druckeinrichtung (50) werden die formschlüssigen Verbindungen, ebenso wie die elektrische Kontaktierung ausgebildet. Durch die ausgezeichnete Dauerhaltbarkeit, auch bei hohen Betriebstemperaturen und einer Vielzahl von Temperaturwechseln, der formschlüssigen druckkontaktierten elektrischen Verbindungen ist diese Anordnung (1) besonders bevorzugt für Anwendungen bei rauen Umgebungsbedingungen.

Fig. 2 zeigt eine zweite Ausgestaltung einer erfindungsgemäßen Anordnung (1). Hierbei ist eine Teilschaltung einer Gleichrichterschaltungsanordnung dargestellt. Zwei erste Metallformkörper (60) bilden hierbei die Gleichstromanschlussleitungen. Auf der Gleichstromanschlussleitung positiver Polarität ist hierbei eine Mehrzahl von Leistungsbauelementen (10), hier wiederum Leistungsdioden, ohne dies auf diesen Bauelementetyp zu beschränken, angeordnet. Jede Leistungsdiode (10) ist im Verbund mit je einem zweiten Metallformkörper (20) ausgebildet und mit ihrer Kathode elektrisch leitend mit der Gleichstromanschlussleitung (60) verbunden. Die jeweilige Anode der Leistungsdioden (10) ist mit einer zugeordneten Kontakteinrichtung (32) einer Verbindungseinrichtung (30) elektrisch leitend verbunden. Diese Verbindungseinrichtung (30) bildet die Wechselstromanschlussleitung der Anordnung (1).

In analoger Weise ist die Gleichstromanschlussleitung negativer Polarität mit den Kathoden der hierauf angeordneten Leistungsdioden (10) verbunden. Deren Anoden sind wiederum mit der Wechselstromanschlussleitung (30) elektrisch leitend verbunden.

Die elektrisch leitenden Verbindungen zwischen den Gleichstromanschlussleitungen (60) und den zweiten Metallformkörpern (20) sowie zwischen der Wechselstromanschlussleitung (30) mit den zugeordneten Anschlussflächen der Leistungsdioden (10) sind jeweils formschlüssig ausgebildet. Hierzu weist die Anordnung eine Druckeinrichtung (50) auf, die hier gebildet wird durch eine federbelastete, geeignet elektrisch isolierte, Schraubverbindung (54) zwischen den beiden Gleichstromanschlussleitungen (60). Die beispielhaft mit Tellerfedern (56) ausgebildete Druckeinrichtung (50) beaufschlagt die formschlüssigen Verbindungen mit Druck jeweils in Richtung der Gleichstromanschlussleitungen (60). Hierdurch entsteht die bekannte dauerhaltbare Druckkontaktierung. Zur elektrischen Isolation der beiden Gleichstromanschlussleitungen (60) zueinander weist die Druckeinrichtung (50) eine die Schraubverbindung geeignet umschließende Isolierung (64) an mindestens einer Gleichstromanschlussleitung (60) auf.

Jeweils ein Verbund aus Leistungsbauelement (10) und zweitem Metallformkörper (20) wird durch ein eigenes Gehäuse (40) umschlossen. Dieses ist als Kunststoffformkörper mit jeweils einer elastischen und temperaturbeständigen Dichteinrichtung (44) zu den Stromanschlussleitungen (30, 60) ausgebildet. Es kann bevorzugt sein eine Mehrzahl von Leistungsbauelement mit zugeordneten zweiten Metallformkörpern mit einem gemeinsamen Gehäuse zu umschließen.

## Patentansprüche

1. Druck kontaktierte Anordnung (1) mit mindestens einem Leistungsbauelement (10), einer Verbindungseinrichtung (30) und mindestens einem ersten Metallformkörper (60) zur Wärmeabfuhr, wobei das. Leistungsbauelement (10) einen Halbleiterkörper mit mindestens einem pn- Übergang aufweist, dieses mit seiner ersten Hauptfläche dem ersten Metallformkörper (60) zugewandt angeordnet und elektrisch leitend mit diesem verbunden ist und mit seiner zweiten Hauptfläche mit einer Kontakteinrichtung (32) der Verbindungseinrichtung (30) elektrisch leitend verbunden ist,
wobei ein Gehäuse (40) mindestens ein Leistungsbauelement (10) umschließt und mittels mindestens einer Dichteinrichtung (44) zum ersten Metallformkörper (60) und zur Verbindungseinrichtung (30) hin abschließt und
wobei eine Druckeinrichtung (50) Druck auf das Gehäuse (40) und / oder die Verbindungseinrichtung (30) in Richtung des ersten Metallformkörpers (60) einleitet.

2. Anordnung nach Anspruch 1
wobei zwischen Leistungsbauelement (10) und erstem Metallformkörper (60) mindestens ein weiterer Metallformkörper (20) angeordnet ist.

3. Anordnung nach Anspruch 2
wobei dieser weitere Metallformkörper (20) mit dem Leistungsbauelement (10) mittels einer Drucksinterverbindung verbunden ist.

4. Anordnung nach Anspruch 1
wobei das Gehäuse (40) das Leistungsbauelement (10) und teilweise die Verbindungseinrichtung (30) umschließt.

5. Anordnung nach Anspruch 1
wobei die Dichteinrichtung (44) elastisch ausgebildet ist und eine Temperaturbeständigkeit von über 200°C aufweist.

6. Anordnung nach Anspruch 1
wobei das Leistungsbauelement (10) eine Diode, ein Thyristor oder ein Transistor ist.

7. Anordnung nach Anspruch 1
wobei das Gehäuse (40) aus einem isolierenden Kunststoff ausgebildet.
